Europäisches Patentamt

European Patent Office

Office européen des brevets

(19)

(11) EP 0 596 568 B1

(12) # FASCICULE DE BREVET EUROPEEN

(45) Date de publication et mention
de la délivrance du brevet:
**29.04.1998  Bulletin 1998/18**

(51) Int Cl.[6]: **H03F 3/60**

(21) Numéro de dépôt: **93203038.0**

(22) Date de dépôt: **29.10.1993**

(54) **Dispositif semiconducteur comprenant un circuit amplificateur distribué monolithiquement intégré, à large bande et fort gain**

Halbleitervorrichtung mit einer monolithisch integrierten Kettenverstärkerschaltung mit grosser Bandbreite und hohem Verstärkungsgrad

Semiconductor device comprising a monolithic integrated distributed amplifier circuit with wide bandwidth and high gain

(84) Etats contractants désignés:
**DE FR GB IT**

(30) Priorité:  **04.11.1992  FR 9213242**

(43) Date de publication de la demande:
**11.05.1994  Bulletin 1994/19**

(73) Titulaires:
• **LABORATOIRES D'ELECTRONIQUE PHILIPS S.A.S.**
  **94450 Limeil-Brévannes (FR)**
  Etats contractants désignés:
  **FR**
• **Philips Electronics N.V.**
  **5621 BA Eindhoven (NL)**
  Etats contractants désignés:
  **DE GB IT**

(72) Inventeurs:
• **Gamand, Patrice, Société Civile S.P.I.D.**
  **F-75008 Paris (FR)**
• **Caux, Christian Société Civile S.P.I.D.**
  **F-75008 Paris (FR)**

(74) Mandataire: **Lottin, Claudine**
  **Société Civile S.P.I.D.**
  **156, Boulevard Haussmann**
  **75008 Paris (FR)**

(56) Documents cités:
EP-A- 0 472 357          DE-A- 3 726 743
GB-A- 2 146 195          US-A- 4 864 250

• 1991 IEEE MTT-S INTERNATIONAL MICROWAVE SYMPOSIUM DIGEST vol. 2 , 10 Juin 1991 , BOSTON US pages 437 - 440 M.M. ODA 'A STABLE GAAS 6-20 GHZ HIGH GAIN AND POWER TWA'

## Description

L'invention concerne un dispositif semiconducteur comprenant un circuit amplificateur du type distribué monolithiquement intégré sur un substrat, fonctionnant dans le domaine des hautes et/ou des hyperfréquences, ce circuit distribué comprenant une pluralité d'étages couplés ayant chacun au moins un transistor avec des électrodes, dont au moins une de ces électrodes, dite première électrode, est reliée individuellement à la masse en alternatif.

L'invention trouve son application dans la réalisation de circuits hyperfréquences monolithiquement intégrés (en anglais MMICS pour Monolithic Microwave Integrated Circuits) pour l'utilisation dans le domaine des télécommunications.

Un amplificateur distribué est déjà connu du brevet US 4 853 649. Ce document décrit un amplificateur comprenant une pluralité d'étages à transistors à effet de champ couplés, dont les grilles sont connectées à une ligne de grille et les drains connectés à une ligne de drain, ces lignes de grille et drain étant formées d'inductances. D'autre part, dans cet amplificateur, les sources des transistors sont munies d'un circuit d'autopolarisation pour régler le potentiel continu de source à une valeur donnée.

Ce circuit d'autopolarisation de source, qui est appliqué individuellement à chaque transistor de l'amplificateur distribué, comprend une capacité et une résistance disposées en parallèle entre chaque source et la masse.

La capacité sert à mettre la source à la masse en hyperfréquence. Elle doit donc avoir une valeur suffisante pour réaliser un court-circuit en hyperfréquence, par exemple 3 à 4 fois la valeur de la capacité grille-source du transistor.

La résistance sert à ajuster la valeur du potentiel continu de source par rapport à la masse. Elle doit donc avoir une valeur suffisamment grande pour qu'un potentiel convenable, non négligeable, s'instaure à ses bornes.

Cet agencement résistance-capacité produit un effet néfaste qui consiste dans la création, ou l'amplification, d'oscillations qui n'ont déjà que trop tendance à se produire dans un amplificateur distribué à fort gain.

D'autre part, cet agencement est appliqué à des transistors du type dit interdigité, ayant un doigt de drain, deux doigts de grille disposés de part et d'autre du doigt de drain, et en outre deux doigts de source disposés de part et d'autre de l'ensemble.

Dans une mise en oeuvre du circuit connu, les transistors sont disposés en ligne sur un substrat, avec les électrodes parallèles d'un transistor à l'autre, les doigts de source d'un transistor se trouvant ainsi en regard d'un doigt de source du transistor précédent et d'un doigt de source du transistor suivant, sauf pour le premier et le dernier transistors.

Entre chaque transistor est disposée une métallisation pour former un plot de masse. Cette métallisation est connectée à un plan de masse, réalisé sur la face opposée du substrat, au moyen d'un trou métallisé.

Dans une mise en oeuvre particulière du circuit connu, illustrée par la figure 15 du document cité, chaque doigt de source est connecté par un pont à air à une capacité plane réalisée en surface du plot de masse, ce qui fournit donc deux capacités réalisées en vis-à-vis entre les transistors et en ligne avec ces derniers. Pour chaque transistor, un seul des doigts de source est prolongé par une ligne conductrice pour raccorder ce doigt de source à une résistance disposée dans une partie de la surface du substrat entre la ligne conductrice et le plot de masse, mais non pas en ligne avec les transistors.

Selon le document cité, cette disposition a été choisie pour éviter de modifier les dimensions des lignes hyperfréquences formant des inductances qui relient entre eux les drains des transistors pour former la ligne de drain, ainsi que celles des lignes hyperfréquences ayant une fonction similaire pour former la ligne de grille.

Le problème est en effet que les capacités des circuits d'autopolarisation à réaliser entre doigts de source et plots de masse, ont, du fait de leur fonction, des dimensions assez conséquentes ; mais par leur structure plane elles peuvent être réalisées en surface du plot de masse, et, moyennant la formation d'une rainure d'isolation pratiquée entre deux capacités en vis-à-vis, elles sont intégrables sans provoquer une trop forte augmentation de la distance entre transistors. Par contre, il n'est pas possible, dans cette mise en oeuvre, de placer aussi les résistances des circuits d'autopolarisation en ligne avec les transistors et les capacités, car leur insertion entre les transistors provoquerait de trop grands changements des dimensions des lignes de grille et drain par rapport à un même circuit non muni de systèmes d'autopolarisation de source, dû au fait que les dimensions de ces résistances sont assez conséquentes.

Dans la mise en oeuvre décrite ci-dessus, les deux doigts de source d'un même transistor ne sont pas reliés entre eux, et seul un de ces doigts est muni du circuit R-C d'autopolarisation. Donc les transistors sur la figure 15 du document cité fonctionnent chacun comme une moitié de transistor.

D'autre part, on notera que les résistances des circuits d'autopolarisation sont disposées exactement entre les sources des transistors et la masse, du fait que les inductances des trous métallisés reliant les plots de masse au plan de masse sont négligeables devant les impédances constituant ces circuits d'autopolarisation et ne sont donc pas prises en compte dans leur fonctionnement.

La nécessité de réaliser des amplificateurs à fort gain, et qui sont large bande jusqu'à des hautes ou hyperfréquences, a fait de l'amplificateur distribué un élément de choix pour ce type d'application.

La technologie choisie pour réaliser l'amplificateur distribué connu du document cité est du type microruban (en anglais MICROSTRIP).

Dans cette technologie, une première face, dite face avant du substrat, qui est ici en GaAs, porte les éléments actifs, des rubans conducteurs pour former les lignes de transmission, et des plages métallisées pour former les plots de masse. Et la seconde face du substrat, dite face arrière, porte un plan métallisé pour former la masse. De sorte que l'impédance des lignes est fonction de la largeur et de la longueur des rubans conducteurs de la première face, et de l'épaisseur du substrat. Par ailleurs des trous métallisés (en anglais VIA HOLES), localisés dans les parties centrales des plots de masse sont constitués à travers le substrat, pour ramener le potentiel du plan de masse de la face arrière jusque sur ces plots de masse sur la face avant du substrat.

Le document cité enseigne que lorsque des moyens sont mis en oeuvre pour optimiser le circuit amplificateur distribué dans le but d'augmenter la largeur de la bande passante et/ou augmenter le gain, alors il apparaît un inconvénient : les éléments parasites inhérents au circuit génèrent des oscillations.

En particulier en hautes et hyperfréquences, la capacité parasite grille-drain ($C_{gd}$) devient un paramètre très critique, et des oscillations apparaissent à des fréquences supérieures à celle de la bande passante de l'amplificateur.

Il existe dans l'état de la technique d'autres circuits distribués tels que des mélangeurs, qui sont formés d'étages par exemple du type cascode et qui sont sujets aux mêmes inconvénients que les amplificateurs distribués.

Un but de l'invention est de fournir des moyens pour réaliser un dispositif ayant un circuit intégré distribué, en se prémunissant contre l'apparition d'oscillations du côté des fréquences élevées de la bande de fréquences de fonctionnement.

Ce but est atteint au moyen du dispositif décrit dans le préambule et en outre caractérisé en ce que, dans chaque étage considéré, en alternatif, ladite première électrode est reliée à la masse par deux branches, unedite première branche connectée directement à un premier plot de masse, et unedite seconde branche connectée à travers une résistance à un second plot de masse.

Un but de l'invention est de fournir un dispositif ayant un circuit distribué facilement intégrable.

Ce but est atteint au moyen de ce dispositif de plus caractérisé en ce que, dans le circuit distribué, les étages sont montés les uns vis-à-vis des autres de telle manière que, pour chaque étage considéré le premier plot de masse est commun avec le second plot de masse de l'étage précédent ou de l'étage suivant, et le second plot de masse est commun avec le premier plot de masse de l'étage suivant ou de l'étage précédent respectivement, en sorte que, par cet agencement, en alternatif, dans chaque étage considéré ladite première électrode du transistor est reliée d'une part à la masse par l'inductance du premier plot de masse, et d'autre part auxdites premières électrodes des étages précédents et suivants par les résistances de leurs secondes branches respectives.

Un autre but de l'invention est de proposer un dispositif ayant un circuit amplificateur dont les performances sont améliorées par rapport à celles du circuit connu de l'état de la technique.

Ce but est atteint au moyen de ce dispositif de plus caractérisé en ce que que le circuit distribué est un amplificateur large bande à fort gain, ce circuit amplificateur comprenant une pluralité d'étages couplés ayant chacun au moins un transistor à effet de champ dont la source constitue ladite première électrode et dont la grille et le drain sont reliés respectivement à une ligne dite de grille et à une ligne dite de drain, formées d'inductances.

Un autre but de l'invention est de proposer un dispositif ayant un circuit amplificateur qui est facilement intégrable dans une technologie très performantes.

Ce but est atteint au moyen de ce dispositif de plus caractérisé en ce que, dans ce circuit amplificateur, chaque transistor est du type interdigité selon lequel la source est constituée d'au moins deux plots d'électrode de source, dits plots externes, topologiquement disposés de part et d'autre des autres plots d'électrodes interdigités de ce transistor, en ce que pour chaque transistor, tous les plots d'électrode de source sont connectés directement entre eux au moyen d'un conducteur, et en ce que l'un des deux plots externes d'électrode de source dit premier plot forme ladite première branche directement connectée au premier plot de masse et l'autre de ces deux plots externes d'électrode de source dit second plot forme ladite seconde branche connectée au second plot de masse à travers ladite résistance.

Dans une mise en oeuvre particulière, ce dispositif est caractérisé en ce que, les transistors pour former l'amplificateur distribué sont topologiquement disposés en ligne à la surface du substrat, avec leurs plots d'électrodes interdigités disposés perpendiculairement à cette ligne, chaque transistor ayant ledit second plot d'électrode de source en regard dudit premier plot d'électrode de source du transistor suivant du circuit amplificateur, en ce que les plots de masse partagés par ces deux transistors sont topologiquement disposés entre ces transistors et alignés avec eux, de manière adjacente audit second et audit premier plots d'électrode de source en regard, et en ce que pour chaque transistor ladite résistance de faible valeur est topologiquement réalisée par chevauchement entre ledit second plot d'électrode de source et le plot de masse qui lui est adjacent.

Un autre but de l'invention est de fournir des moyens pour réaliser un dispositif ayant un circuit amplificateur distribué dont la bande passante est augmentée vers les fréquences élevées, sans pour autant montrer un risque d'oscillations du côté des fréquences élevées.

Ce but est atteint au moyen de ce dispositif, de plus caractérisé en ce que, chaque étage de l'amplificateur distribué est du type cascode dans lequel on associe à chaque transistor dit transistor bas de l'amplificateur distribué monté en source commune à la masse, un transistor dit transistor haut, qui est monté en grille commune à la masse en hautes et/ou hyperfréquences, grille qui constitue ladite première électrode de cet étage cascode et qui est isolée de la masse en continu par des capacités.

L'invention est décrite ci-après en détail, en référence avec les figures schématiques annexées, dont :

- la figure 1 représente un exemple de schéma fonctionnel de circuit amplificateur distribué.
- la figure 2a représente un exemple de schéma fonctionnel pour réaliser un circuit amplificateur distribué dont la bande passante est étendue vers les fréquences élevées ;
- la figure 2b représente une mise en oeuvre particulière du circuit de la figure 2a ;
- la figure 3a représente deux étages consécutifs d'amplificateur distribué, et montre la connexion des sources des transistors à des trous métallisés ;
- la figure 3b représente le schéma équivalent au montage de la figure 3a ;
- la figure 3c représente un exemple de topologie pour mettre en oeuvre le montage de la figure 3a.
- la figure 4 représente le coefficient de dispersion S21 en amplitude en dB, la courbe A en trait discontinu correspondant à un amplificateur distribué connu, et la courbe B en trait plein correspondant à un amplificateur distribué muni de petites résistances de connexion d'une électrode de source sur deux à un trou métallisé conformément à l'invention.

L'invention s'applique à de nombreux circuits distribués fonctionnant en haute et/ou hyperfréquences et notamment à des amplificateurs distribués et à des mélangeurs distribués. Ces derniers ont une structure comparable à celle des amplificateurs distribués du type cascode.

La description ci-après concerne à titre d'exemple, un circuit amplificateur distribué intégré dans un dispositif semiconducteur.

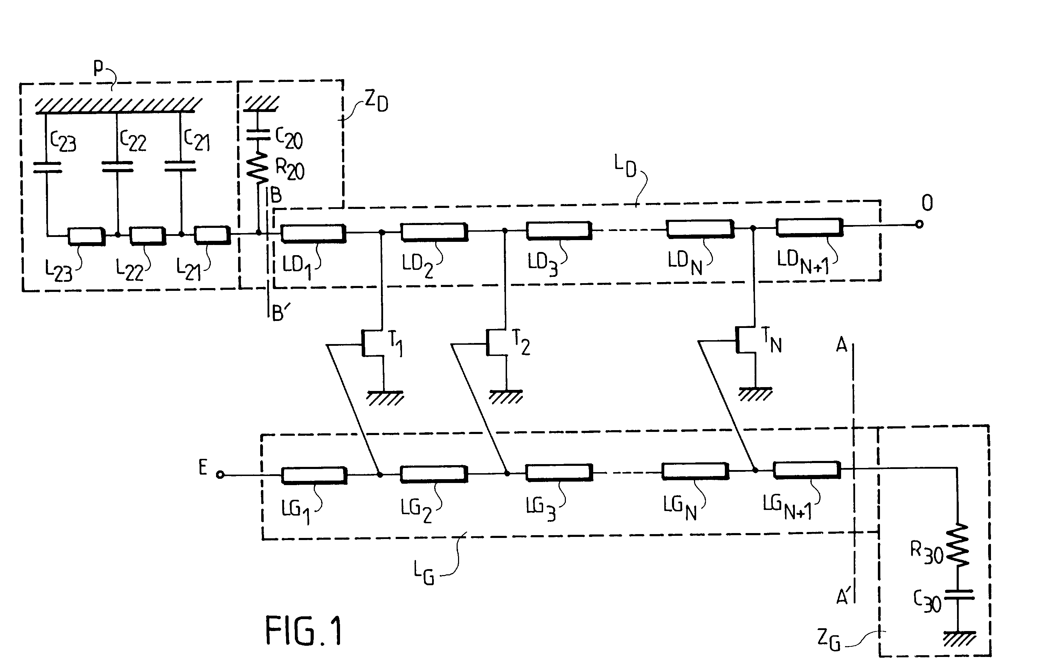

En référence avec la figure 1, un amplificateur distribué représenté à titre d'exemple non limitatif, comprend une pluralité de transistors à effet de champ $T_1$, $T_2$... $T_N$... montés en source commune, une première ligne $L_G$ formée de tronçons de lignes hyperfréquences d'impédance $LG_1$, $LG_2$... $LG_{N+1}$ respectivement, et une seconde ligne $L_D$ formée de tronçons de lignes hyperfréquences d'impédance $LD_1$, $LD_2$... respectivement.

Les grilles des transistors $T_1$, $T_2$... sont connectées de façon périodique à la ligne $L_G$ dite ligne de grille, entre les tronçons de lignes hyperfréquences $LG_1$, $LG_2$... respectivement.

Les drains des transistors $T_1$, $T_2$... sont connectés de façon périodique à la ligne $L_D$ dite ligne de drain, entre les tronçons de lignes hyperfréquences $LD_1$, $LD_2$... respectivement.

Un signal d'entrée E hyperfréquence est appliqué à cet amplificateur sur l'extrémité de la ligne de grille $L_G$, et la sortie O hyperfréquence amplifiée est prélevée sur l'extrémité de la ligne de drain.

Les impédances propres $LG_1$, $LG_2$ de la ligne de grille $L_G$ forment avec les capacités intrinsèques grille-source des transistors à effet de champ $T_1$, $T_2$..., une ligne hyperfréquence distribuée dite ligne de transmission artificielle.

Il en est de même pour la ligne de drain $L_D$, entre les impédances propres $LD_1$, $LD_2$ et les capacités drain-source des transistors à effet de champ $T_1$, $T_2$...

Le principe de fonctionnement de l'amplificateur distribué est basé sur la propagation des signaux le long des lignes de transmission artificielles ainsi constituées. Lorsque le signal hyperfréquence E est appliqué sur la ligne de grille, il se propage en excitant chaque transistor qui fournit alors une puissance de sortie capable de se propager sur la ligne de drain. Si la vitesse de phase des deux lignes de transmission artificielles est identique, la puissance s'additionne en phase lors de la propagation le long de la ligne drain. Il est alors possible d'obtenir une amplification dans une bande de fréquence, qui est limitée entre autres par la fréquence de coupure des lignes de transmission.

Lorsque l'amplificateur fonctionne à différentes fréquences dans le domaine des hyperfréquences, il est clair que les tronçons $LG_1$, $LG_2$, .. $LD_1$, $LD_2$... peuvent représenter des petites sections de lignes de transmission pour des fréquences telles que 20 GHz. La longueur de ces tronçons est calculée de manière à assurer le déphasage nécessaire au bon fonctionnement de l'amplificateur.

L'amplificateur comprend en outre au moins un circuit de polarisation. Un tel circuit de polarisation P est prévu à l'extrémité de la ligne $L_D$ opposée à la sortie 0. Ce circuit de polarisation P est constitué par exemple de tronçons de lignes de transmission hyperfréquences $L_{21}$, $L_{22}$, $L_{23}$... et de capacités $C_{21}$, $C_{22}$, $C_{23}$ montées entre la masse et les noeuds de liaisons entre chacun de ces tronçons $L_{21}$, $L_{22}$, $L_{23}$...

Les lignes de grille et drain $L_G$ et $L_D$ sont en outre fermées sur une charge respectivement $Z_G$ et $Z_D$.

La charge appliquée à la ligne de grille $L_G$ peut être formée d'une résistance $R_{30}$ et d'une capacité $C_{30}$ montées en série et placées entre la sortie de la ligne $L_G$ et la masse.

La fréquence de fonctionnement d'un tel amplificateur distribué est limitée théoriquement d'une part par la fréquence de coupure des transistors à effet de champ, et d'autre part par la fréquence de coupure des lignes artificielles comme dit plus haut.

En fait, la fréquence de coupure réelle du circuit est bien inférieure à ces fréquences théoriques, car cette fréquence de coupure est limitée par des réflexions multiples et des phénomènes de résonances qui en découlent. Ces phénomènes sont dus à la variation des impédances caractéristiques des lignes lorsque la fréquence de fonctionnement varie, et la seule amélioration de la polarisation ne suffit pas pour supprimer ces phénomènes. Ces phénomènes de réflexions apparaissent en particulier sur la ligne de grille au niveau du plan AA' entre le dernier tronçon de ligne $L_{N+1}$ et la charge $Z_G$, l'onde sur la ligne de grille se propageant de l'entrée E en direction de cette charge $Z_G$.

Sur la ligne de drain, une partie de l'onde se dirige vers le plan BB' entre le tronçon de ligne $L'_1$ et la charge $Z_D$. Mais cette dernière onde incidente arrivant sur BB' est très atténuée, si bien que les réflexions sont très faibles et ne nécessitent pas l'adjonction d'un circuit de compensation.

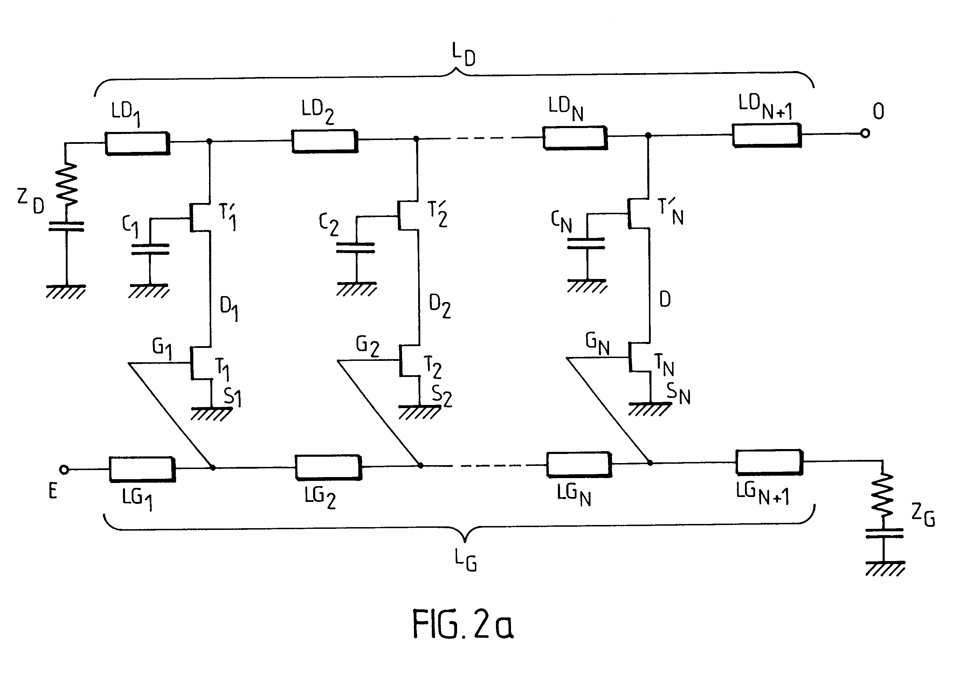

Pour augmenter la bande passante d'un amplificateur distribué tel que décrit plus haut, on peut, par exemple, en référence avec la figure 2a, appliquer à chacun de ses étages, un montage dit cascode. Ceci évite les pertes de gain à fréquence élevée qui apparaissaient dans le circuit connu du document cité au titre d'état de la technique.

Chaque étage cascode comprend, monté entre le drain du transistor $T_1$, $T_2$, $T_N$ d'un étage de l'amplificateur distribué conventionnel, et la ligne de drain $L_D$, un transistor supplémentaire $T'_1$, $T'_2$... $T'_N$, dont la grille et reliée à la masse à travers une capacité, respectivement $C_1$, $C_2$, $C_N$.

Le montage cascode consiste donc à associer, dans chaque étage de l'amplificateur distribué, un transistor haut $T'_1$, $T'_2$... $T'_N$ monté en grille commune, qui est à la masse en hyperfréquences à travers la capacité d'isolation en continu $C_1$...$C_N$, à un transistor bas $T_1$, $T_2$,...$T_N$ monté en source commune.

Ainsi, on obtient l'avantage que le couplage entre les lignes de grille et de drain est diminué, et que, de cette façon, la bande passante du circuit amplificateur distribué est notablement augmentée du côté des fréquences élevées sans perte de gain.

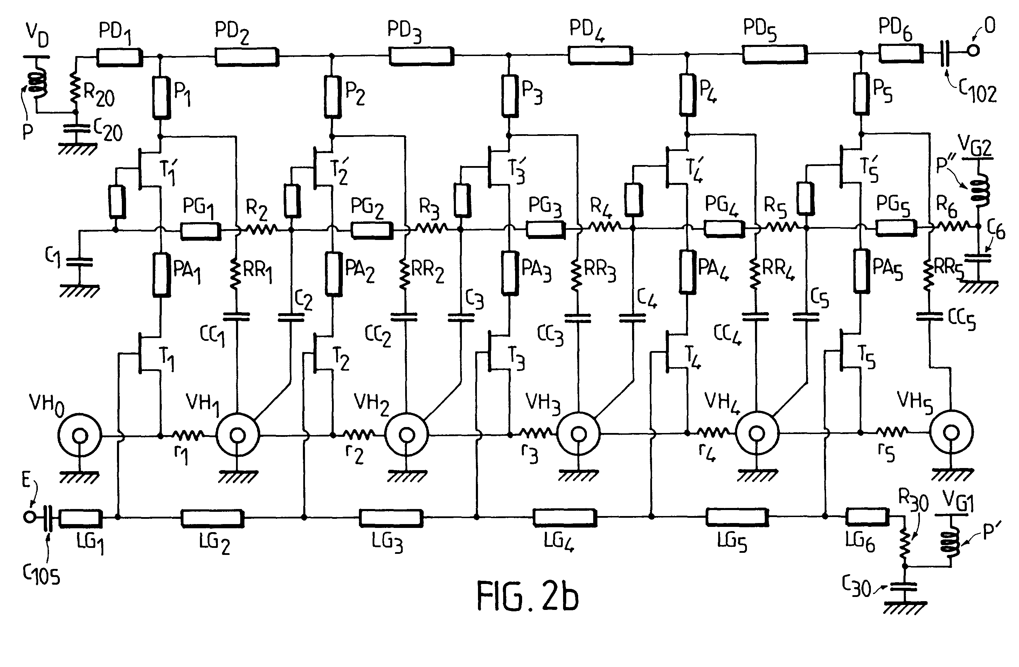

Dans une mise en oeuvre du montage cascode décrit plus haut, et en référence avec la figure 2b, les différents éléments actifs sont liés entre eux et aux ligne de grille et ligne de drain par des tronçons de lignes hyperfréquences.

Ainsi les drains des transistors hauts $T'_1$, $T'_2$,...$T'_N$, sont reliés à la ligne de drain par des lignes, respectivement $P_1$, $P_2$... $P_N$, la ligne de drain étant alors constituée des tronçons de ligne $PD_1$, $PD_2$,... $PD_{N+1}$.

Les transistors haut et bas, $T'_1$ et $T_1$, $T'_2$ et $T_2$, $T'_N$ et $T_N$ sont reliées par des lignes respectivement $PA_1$, $PA_2$, $PA_N$.

Les grilles des transistors hauts sont reliées les unes aux autres par des tronçons de lignes $PG_1$, $PG_2$, $PG_N$.

La ligne de grille est constituée de tronçons de lignes $LG_1$, $LG_2$... $LG_{N+1}$.

De cette façon, les variations d'impédance en fonction de la fréquence sont compensées, les phénomènes de résonnance dus aux réflexions multiples sont supprimés, l'effet de couplage entre les lignes est atténué. La polarisation devient plus efficace : les transistors travaillent dans de meilleures conditions.

L'ensemble de ces améliorations permet d'obtenir un élargissement de la bande passante dont la fréquence de coupure se rapproche alors de la fréquence de coupure théorique.

On notera que, dans un amplificateur distribué tel que représenté sur la figure 1, le tronçon de ligne placée sur le drain du transistor $T_1$ dans la position $LG_1$, ne fait pas partie de la charge $Z_D$ mais bien de la ligne de drain $L_D$. De même le tronçon de ligne placé sur la grille du transistor $T_N$ dans la position de $LG_{N+1}$, ne fait pas partie de la charge $Z_G$, mais bien de la ligne de grille $L_G$. Ceci est dû au principe même de fonctionnement d'un amplificateur distribué.

Dans un exemple de réalisation, l'amplificateur distribué selon la figure 2b est formé d'un nombre de 5 transistors à effet de champ. Les tronçons de lignes de transmission sont du type microruban.

Les dimensions des longueurs $L_T$ de grille des transistors, des largeurs $\ell_T$ de grille des transistors, leur tension de pincement $V_T$, la largeur W des lignes de transmission, la longueur D des lignes de transmission sont données dans le tableau I dans le cas d'un amplificateur à 5 étages réalisé sur arséniure de gallium (GaAs).

Dans l'exemple de mise en oeuvre illustrée par la figure 2b concernant un amplificateur distribué à étages cascodes, la ligne de drain est polarisée à travers un circuit P relié à une tension continue $V_D$, appliqué à l'extrémité opposée à la sortie 0, la ligne de grille est polarisée à travers un circuit P' relié à une tension continue $V_{G1}$ appliquée à l'extrémité opposée à l'entrée E, et la ligne de grille des transistors hauts montés en cascode est polarisée à son extrémité de sortie à travers un circuit P'' relié à une alimentation continue $V_{G2}$. Les circuit de polarisation P, P', P'' sont de préférence constitués par des inductances. Les valeurs des tensions continues de polarisation $V_D$, $V_{G1}$, $V_{G2}$ sont données dans le tableau I.

Comme il a été dit précédemment, d'une manière générale, dès que l'homme du métier cherche à obtenir, dans un amplificateur distribué, une augmentation de la bande passante en même temps qu'un gain élevé, il se produit des oscillations qui apparaissent à des fréquences supérieures à celles de la bande passante.

Dans le cas où l'homme du métier a choisi, pour augmenter la bande passante de l'amplificateur distribué, de réaliser le montage cascode décrit précédemment, cet inconvénient peut être minimisé en appliquant à chaque étage un premier filtre R-C formé d'un résistance respectivement $R_2$... $R_{N+1}$ montée dans la ligne de grille des transistors hauts cascodes $T'_1$, $T'_2$... entre les lignes $P_{G1}$, $P_{G2}$... et associée en série avec la capacité d'isolation de grille $C_1$, $C_2$... $C_N$, et un second filtre R-C formé d'une résistance, respectivement $RR_1$, $RR_2$,... $RR_N$, montée en série avec une capacité d'isolation respectivement $CC_1$, $CC_2$... $CC_N$, ces derniers éléments $RR_1$-$CC_1$, $RR_2$-$CC_2$ étant disposés entre le drain des transistors hauts $T'_1$, $T'_2$... $T'_N$, et la masse. La grille des transistors hauts $T_1$... $T'_N$ voit donc la masse d'une part directement et d'autre part à travers les résistances $R_2$... $R_{N+1}$ en hyperfréquences.

Les valeurs de ces éléments $R_1...R_N$, $C_1...C_N$, $RR_1...RR_N$, $CC_1...CC_N$ sont également donnés dans le tableau I.

L'introduction des résistances $R_2.... R_{N+1}$ dans la ligne de grille des transistors cascodes est un facteur important de stabilité.

Néanmoins, l'éventualité de voir apparaître des oscillations, lorsque l'on adopte des moyens pour augmenter la bande passante d'un amplificateur distribué, tout en maintenant un gain élevé, ne peut jamais jusqu'à ce jour être évité.

En effet, toute mesure prise pour atténuer les oscillations, diminue automatiquement le gain dans des proportions qui peuvent être rédhibitoires.

La présente invention offre une solution à ce problème dans la mesure où l'amplificateur est réalisé dans une technologie incluant des transistors intergités dont une des électrodes, dite première électrode, dans le cas présent l'électrode de source, est reliée à la masse par des plots de masse de grande surface.

En référence avec l'état de la technique cité, on a vu que les circuits amplificateurs distribués sont réalisés de préférence au moyen d'une technologie de transistors interdigités, ces transistors pouvant être aussi bien des MESFETs que des HEMTs à plusieurs doigts de grille (au moins deux), un ou plusieurs doigts de drain et plusieurs doigts de source (au moins deux) dont au moins un doigt de source est disposé de part et d'autre des autres doigts.

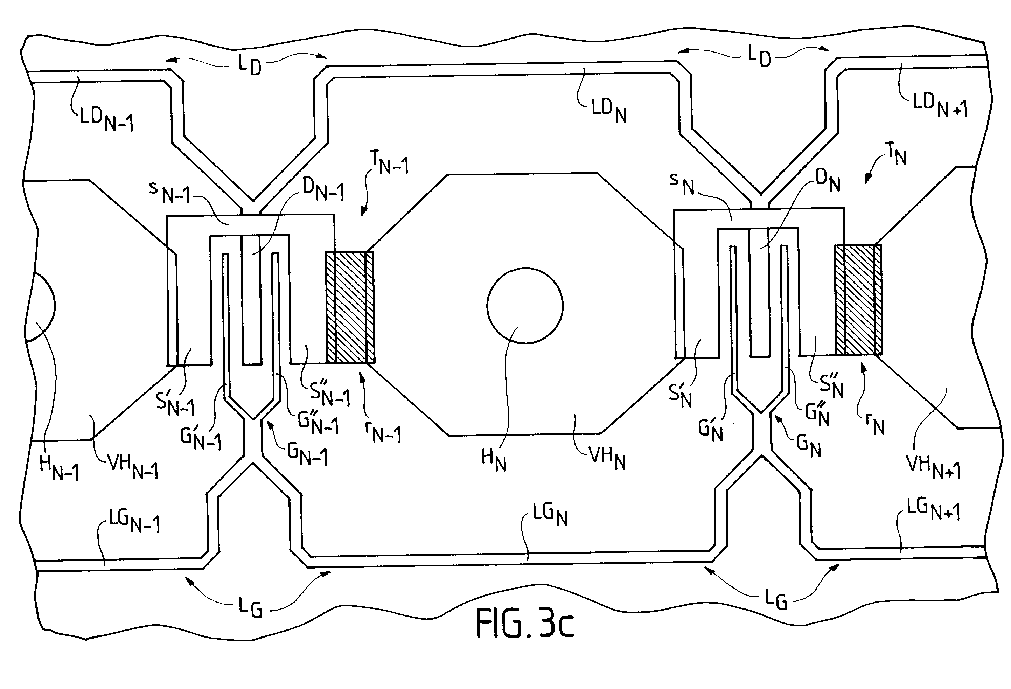

Ainsi en référence avec la figure 3c, un transistor du Nième étage de l'amplificateur comprend au moins un doigt de drain $D_N$, disposé entre deux doigts de grille $G_N$, respectivement $G'_N$ et $G''_N$ ; il comprend aussi deux contacts (ou plots) d'électrode de source $S_N$, respectivement $S'_N$ et $S''_N$, dits premier et second plots d'électrode de source, disposés de l'autre côté des doigts de grille $G'_N$, $G''_N$, par rapport au doigt de drain $D_N$.

Le doigt de drain $D_N$ est relié aux tronçons de ligne $LD_N$ et $LD_{N+1}$ de la ligne de drain $L_D$ par des portions de ligne, et les deux doigts de grille $G'_N$, $G''_N$ sont d'abord réunis, puis reliés aux tronçons de ligne $LG_N$ et $LG_{N+1}$ de la ligne de grille $L_G$ également par des portions de ligne.

Les contacts de source dit périphériques (ou externes) $S'_N$ et $S''_N$ sont respectivement adjacents aux plots de masse $VH_N$ et $VH_{N+1}$ respectivement.

Sur la figure 3c, on a représenté deux étages successifs comportant les transistors $T_{N-1}$ et $T_N$, d'un amplificateur distribué tel que représenté schématiquement sur la figure 1, et non pas, pour des raisons de simplicité de dessin, correspondant à l'amplificateur à montage cascode des figures 2a ou 2b. L'homme du métier fera sans peine la transposition nécessaire pour appliquer l'invention à toute sorte d'amplificateurs.

D'une manière générale, pour intégrer à grande échelle les éléments de circuits, dans le domaine des hyperfréquences, les substrats sont choisis en matériaux semiconducteurs, favorablement du groupe III-V comme par exemple l'arséniure de gallium (GaAs), mais beaucoup d'autres matériaux semiconducteurs, ou bien céramiques sont possibles. Et en outre la technologie est choisie du type microruban, (en anglais MICROSTRIP) dans laquelle les conducteurs en forme de ruban constituant des lignes, et les éléments actifs, sont sur une des faces du substrat, l'autre face de ce substrat portant un plan de masse. Ainsi, la densité d'intégration des éléments peut être élevée.

De préférence, pour réaliser un amplificateur distribué, toutes les électrodes des transistors correspondants de tous les étages sont disposées parallèlement, et de plus ces transistors sont en ligne, de sorte que les électrodes de source périphériques se trouvent chacune en regard d'une électrode de source d'un étage précédent ou suivant, sauf pour le premier et le dernier étage.

Dans ces conditions, deux électrodes de source périphériques (ou externes) en regard partagent le même plot de masse.

Cependant, il faut prendre en compte qu'en technologie microruban, pour relier les plots de masse $VH_1...VH_N$ au plan de masse sur la face opposée du substrat, il faut prévoir dans ces plots, des trous métallisés $H_1$, $H_2... H_N$ ramenant le potentiel de masse de la face arrière du substrat sur les métallisations $VH_1... VH_N$.

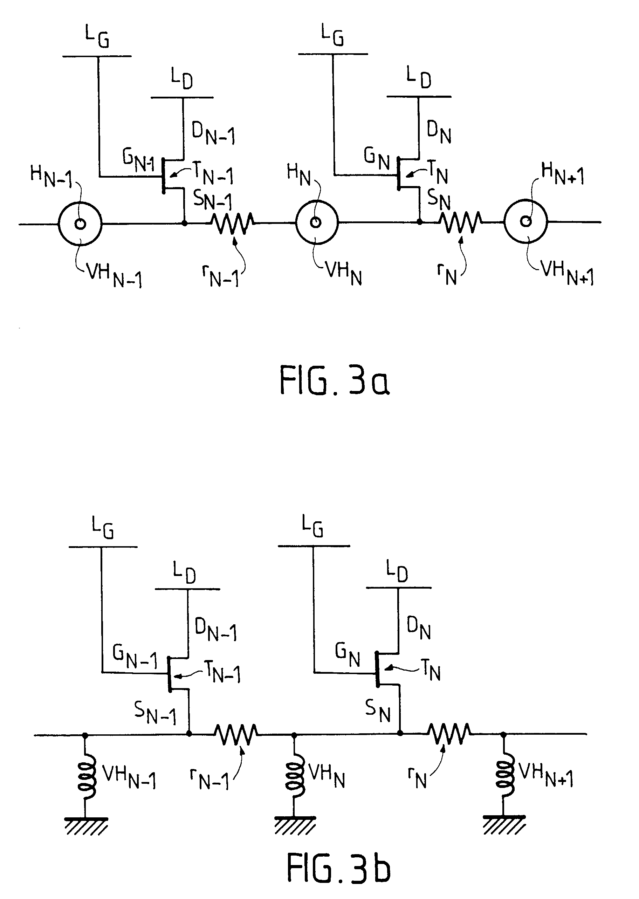

La figure 3a représente schématiquement les deux étages de circuit correspondants à la topologie de la figure 3c, et la figure 3b montre le schéma équivalent à la partie de circuit de la figure 3a. Ainsi les trous métallisés $H_1$, $H_2... H_N$, associés aux plots $VH_1$, $VH_2...VH_N$, disposés conformément à la topologie de la figure 3c, présentent comme montré sur la figure 3b, une inductance de faible valeur, qui ne dégrade pas de façon sensible, les performances du transistor de l'étage correspondant, dans son domaine de fonctionnement en hautes et/ou hyperfréquences.

La mise en oeuvre de l'invention en technologie microruban qui inclut des plots de masse avec trous métallisés comme illustré par les figures 3, n'est pas limitative. L'invention peut être mise en oeuvre dans toute technologie où les plots de masse de grande surface $H_1... H_{N+1}$ sont connectés à des lignes de masse de faible impédance caractéristique comme en technologie coplanaire par exemple.

La valeur typique de cette inductance en technologie microruban est de 20 pH ($20.10^{-12}$H) à 20 GHz ($20.10^9$ Hz), donc chaque source de transistor voit en réalité la moitié, c'est-à-dire 10pH($10.10^{-12}$H), du fait que cette source est reliée à deux plots $VH_{N-1}$ et $VH_N$.

A la fréquence de 20 GHz, chaque source de transistor voit donc une impédance de :

$$10.10^{-12} \times 2\pi \times 20.10^9 \simeq 1{,}2\ \Omega.$$

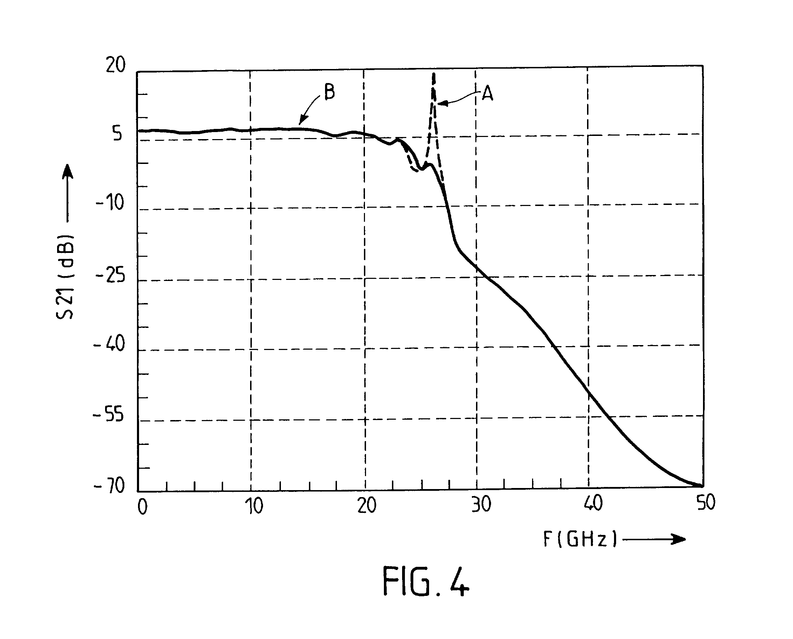

En référence avec la figure 4 qui montre l'amplitude en dB du coefficient S21 d'un amplificateur distribué à étage cascodes, il apparaît sur la courbe A en trait discontinu des oscillations aux fréquences élevées, lorsqu'aucune mesure n'est prise pour les supprimer.

Un tel désavantage doit absolument être évité. L'amplificateur distribué doit voir à la fois sa bande passante augmentée, un fort gain maintenu, et l'éventualité d'apparition d'oscillations aux fréquences supérieures à celles de la bande passante, complètement supprimée.

Selon l'invention la solution trouvée à la prévention des oscillations, sans dégradation du gain, réside dans un moyen qui consiste à placer une résistance r de faible valeur entre un seul des doigts de source et son plot de masse métallisé correspondant.

Par exemple, en référence avec la figure 3c, on placera une résistance de faible valeur $r_N$ dans l'étage du transistor $T_N$, entre le plot d'électrode de source $S''_N$, dit second plot d'électrode de source, et le plot de masse $VH_N$.

On placera aussi une résistance de faible valeur $r_{N-1}$ dans l'étage du transistor $T_{N-1}$, entre ledit second plot d'électrode de source $S''_{N-1}$ et le plot de masse $VH_{N-1}$. Et on fera de même dans chaque étage de l'amplificateur distribué.

Par ailleurs, les deux (ou plus) doigts (ou plots) de source $S'_N$-$S''_N$, seront connectés entre eux par un conducteur $S_N$ réalisé à un autre niveau que les autres parties du transistor (sur la figure 3c le doigt de drain $D_N$) que ce conducteur doit croiser. Et de même dans tous les étages de l'amplificateur.

Ainsi, en référence avec les figures 3a et 3b, la source d'un transistor voit d'une part dans une branche une connexion directe avec un plot de masse muni d'un trou métallisé par un des doigts (ou plots) d'électrode de source (par exemple ledit premier plot $S'_N$ et $H_N$ - $VH_N$) et d'autre part, en parallèle, dans une autre branche, une connexion de l'électrode de source avec un deuxième plot de masse muni d'un trou métallisé (par exemple ledit second plot $S''_N$ et $H_{N+1}$ - $VH_{N+1}$), à travers une résistance $r_N$ de faible valeur.

Cela revient à ce que la source $S_N$ de chaque transistor $T_N$ est reliée d'une part à la masse par une branche contenant seulement une faible inductance de 20 pH, c'est-à-dire $2,5\Omega$ à 20 GHz, et d'autre part aux sources des transistors précédent et suivant par des branches contenant ladite faible résistance $r_N$.

Si l'on choisit la faible résistance $r_N$ d'une valeur de $5\Omega$ par exemple, il s'ensuit que la source $S_N$ du transistor $T_N$ voit une impédance donnée ci-après par $Z_N$ et qui est relative à une faible inductance $L_N$ correspondant à $H_N$ - $VH_N$ disposée entre le noeud de source $S_N$ et la masse, avec en parallèle, une faible inductance $L_{N+1}$ correspondant à $H_{N+1}$ - $VH_{N+1}$ en série avec ladite faible résistance $r_N$ disposée entre le noeud de source $S_N$ et la masse. Le calcul de cette impédance $Z_N$ conduit aux équations suivantes :

$$Z_N = \frac{jL\omega}{r + jL\omega}$$

$$= \frac{r\,L^4\omega}{r^2 + 2\omega^2 L} + j\omega\,\frac{[2L^3\omega^2 + r^2 L]}{r^2 + 2\omega^2 L}$$

Dans ces formules $r = r_N$ et $L = L_N = L_{N+1}$ . De ce calcul, il ressort que la source des transistors $T_N$ est directement reliée à la masse en ce qui concerne la polarisation en continu, et qu'en hyperfréquences la partie réelle de $Z_N$ tend vers r/4 lorsque la fréquence augmente. Il résulte donc de l'utilisation de dites faibles résistances $r_N$ disposées comme selon l'invention que les oscillations peuvent être amorties sans détérioration du gain.

Il a été trouvé expérimentalement en référence avec la figure 4 que cet agencement suffit à amortir les oscillations sans pour autant détériorer le gain de l'amplificateur, comme il est montré sur la courbe B en trait plein.

Sur le plan technologique, comme montré sur la figure 3c, il est aisé à l'homme du métier de disposer les résistances de faible valeur $r_1$, $r_2$, $r_N$ entre un des contacts de source périphériques et le plot de masse $VH_{N+1}$ à trou métallisé adjacent correspondant.

Ce genre de solution est valable pour pratiquement tous les circuits hautes et/ou hyperfréquences actuellement réalisés, du fait qu'ils incluent le plus souvent des transistors interdigités et des plots de masse du genre à trous métallisés ou équivalents. Les résistances $r_N$ étant par principe de faibles valeurs peuvent être réalisées au moyen d'une couche résistive qui vient chevaucher ledit second plot d'électrode de source $S''_N$ d'un transistor $T_N$ et le plot de masse $VH_{N+1}$ adjacent. Ainsi, il n'y a pas lieu de changer la distance qui sépare topologiquement un transistor donné du suivant, et donc les lignes de grille et de drain peuvent rester identiques à ce qu'elles seraient sans les moyens de l'invention.

Comme on a dit plus haut, l'homme du métier peut envisager des mises en oeuvre de l'invention adaptées au cas où les plots de masse ont une structure différente de celle qui est présentée sur les figures 3, par exemple des plots de masse non munis de trous métallisés, mais raccordés à des lignes de masse de faible impédance caractéristique comme en technologie coplanaire par exemple.

# EP 0 596 568 B1

TABLEAU I

| Lignes | D Longueur (μm) | W Largeur (μm) |
|---|---|---|
| PA | 400 | 15 |
| PD | 1255 | 15 |
| LG | 1070 | 23 |
| P | 50 | 15 |
| PG | 760 | 80 |

| Résistances | Valeur (Ω) |
|---|---|
| RR | 3410 |
| R | 100 |
| r | 5 |

| Capacités | Valeur (pF) |
|---|---|
| CC | 0,94 |
| C | 10 |

| Transistors | $L_T$ Longueur de grille (μm) | $\ell_T$ Largeur de grille (μm) | $V_T$ Tension de pincement (V) |
|---|---|---|---|
| T | 4 | 92 | -1 |
| T' | 4 | 92 | -1 |

| Alimentions en continu | Valeur (V) |
|---|---|
| $V_D$ | + 6 |
| $V_{G1}$ | - 0,2 |
| $V_{G2}$ | + 2 |

Dans une variante des valeurs données dans ce tableau, si R = 200 Ω, alors PG peut être amenée à une largeur W = 40 μm.

**Revendications**

1. Dispositif semiconducteur comprenant un circuit amplificateur du type distribué monolithiquement intégré sur un substrat, fonctionnant dans le domaine des hautes et/ou des hyperfréquences, ce circuit distribué comprenant une pluralité d'étages couplés ayant chacun au moins un transistor avec des électrodes, dont au moins une de ces électrodes, dite première électrode, est reliée individuellement à la masse en alternatif, caractérisé en ce que, dans chaque étage considéré, en alternatif, ladite première électrode est reliée à la masse par deux branches, unedite première branche connectée directement à un premier plot de masse, et unedite seconde branche connectée à travers une résistance à un second plot de masse.

2. Dispositif selon la revendication 1, caractérisé en ce que, dans le circuit distribué, les étages sont montés les uns vis-à-vis des autres de telle manière que, pour chaque étage considéré le premier plot de masse est commun avec le second plot de masse de l'étage précédent ou de l'étage suivant, et le second plot de masse est commun avec le premier plot de masse de l'étage suivant ou de l'étage précédent respectivement, en sorte que, par cet agencement, en alternatif, dans chaque étage considéré ladite première électrode du transistor est reliée d'une part à la masse par l'inductance du premier plot de masse, et d'autre part auxdites premières électrodes des étages précédents et suivants par les résistances de leurs secondes branches respectives.

3. Dispositif semiconducteur selon la revendication 2, caractérisé en ce que le circuit distribué est un amplificateur large bande à fort gain, ce circuit amplificateur comprenant une pluralité d'étages couplés ayant chacun au moins un transistor à effet de champ dont la source constitue ladite première électrode et dont la grille et le drain sont reliés respectivement à une ligne dite de grille et à une ligne dite de drain, formées d'inductances.

**4.** Dispositif semiconducteur selon la revendication 3, caractérisé en ce que, dans ce circuit amplificateur, chaque transistor est du type interdigité selon lequel la source est constituée d'au moins deux plots d'électrode de source, dits plots externes, topologiquement disposés de part et d'autre des autres plots d'électrodes interdigités de ce transistor, en ce que pour chaque transistor, tous les plots d'électrode de source sont connectés directement entre eux au moyen d'un conducteur, et en ce que l'un des deux plots externes d'électrode de source dit premier plot forme ladite première branche directement connectée au premier plot de masse et l'autre de ces deux plots externes d'électrode de source dit second plot forme ladite seconde branche connectée au second plot de masse à travers ladite résistance.

**5.** Dispositif semiconducteur selon la revendication 4, caractérisé en ce que chaque résistance qui relie un plot de source à un plot de masse est choisie de faible valeur, et chaque plot de masse est choisi pour constituer, en hyperfréquences, une faible inductance, de manière telle que, par cet agencement, la source de chaque transistor est reliée d'une part à la masse par cette faible inductance et d'autre part aux sources des transistors précédent et suivant par une de ces dites résistances de faible valeur.

**6.** Dispositif selon la revendication 5, caractérisé en ce que, les transistors pour former l'amplificateur distribué sont topologiquement disposés en ligne à la surface du substrat, avec leurs plots d'électrodes interdigités disposés perpendiculairement à cette ligne, chaque transistor ayant ledit second plot d'électrode de source en regard dudit premier plot d'électrode de source du transistor suivant du circuit amplificateur, en ce que les plots de masse partagés par ces deux transistors sont topologiquement disposés entre ces transistors et alignés avec eux, de manière adjacente audit second et audit premier plots d'électrode de source en regard, et en ce que pour chaque transistor ladite résistance de faible valeur est topologiquement réalisée par chevauchement entre ledit second plot d'électrode de source et le plot de masse qui lui est adjacent.

**7.** Dispositif selon l'une des revendications 3 à 6, caractérisé en ce que chaque étage de l'amplificateur distribué est du type cascode dans lequel on associe à chaque transistor dit transistor bas de l'amplificateur distribué monté en source commune à la masse, un transistor dit transistor haut, qui est monté en grille commune à la masse en hautes et/ou hyperfréquences, grille qui constitue ladite première électrode de cet étage cascode et qui est isolée de la masse en continu par des capacités.

**8.** Dispositif selon l'une des revendications précédentes, caractérisé en ce que le circuit amplificateur est monolithiquement intégré sur un substrat au moyen d'une technologie dite microruban, selon laquelle les éléments actifs, les connexions et les plots de masse sont réalisés sur une des faces d'un substrat qui porte un plan de masse sur son autre face, la connexion entre les plots de masse et le plan de masse étant réalisée au moyen de trous métallisés pratiqués dans chaque plot de masse.

**9.** Dispositif selon l'une des revendications précédentes, caractérisé en ce que le circuit amplificateur est monolithiquement intégré sur un substrat en un matériau du groupe III-IV par exemple l'arséniure de gallium (GaAs).

**10.** Dispositif selon l'une des revendications 1 ou 2, caractérisé en ce que le circuit distribué est un mélangeur.

**Patentansprüche**

**1.** Halbleitervorrichtung mit einer monolithisch auf einem Substrat integrierten Kettenverstärkerschaltung zur Funktion im Bereich der Hoch- und/oder Hyperfrequenzen, diese Kettenschaltung enthält eine Vielzahl an gekoppelten Stufen mit jeweils mindestens einem Transistor mit Elektroden, von denen mindestens eine der Elektroden, die sogenannte erste Elektrode, individuell abwechselnd mit der Masse verbunden ist, dadurch gekennzeichnet, daß in jeder betrachteten Stufe abwechselnd die besagte erste Elektrode über zwei Zweige mit der Masse verbunden ist, und ein besagter zweiter Zweig über einen Widerstand an einen zweiten Massekontakt angeschlossen ist.

**2.** Vorrichtung nach Anspruch 1, dadurch gekennzeichnet, daß in der Kettenschaltung die Stufen gegenüber angeordnet sind, derart, daß jede für betrachtete Stufe der erste Massekontakt gleich dem zweiten Massekontakt der vorhergehenden Stufe und der darauffolgenden Stufe ist, und der zweite Massekontakt gleich mit dem ersten Massekontakt jeweils der darauffolgenden Stufe oder der vorhergehenden Stufe ist, damit durch diese Anordnung wechselnd in jeder betrachteten Stufe die besagte erste Elektrode des Transistors einerseits mit der Masse über Induktanz des ersten Massekontakts und andererseits mit den besagten ersten Elektroden der vorhergehenden und darauffolgenden Stufen über die Widerstände ihrer jeweiligen zweiten Zweige verbunden ist.

3. Halbleitervorrichtung nach Anspruch 2, dadurch gekennzeichnet, daß die Kettenschaltung ein Kettenverstärker mit großer Bandbreite und hohem Verstärkungsgrad ist, dieser Verstärker eine Vielzahl an gekoppelten Stufen mit mindestens einem Feldeffekttransistor ausweist, dessen Source die besagte erste Elektrode bildet und dessen Gitter und Drein jeweils an eine sogenannte Gitterleitung und eine sogenannte Drainleitung angeschlossen sind, gebildet aus Induktanzen.

4. Halbleitervorrichtung nach Anspruch 3, dadurch gekennzeichnet, daß in dieser Verstärkerschaltung jeder Transistor vom sogenannten Interdigitationstyp ist, bei dem die Source aus mindestens zwei Source-Elektrodenkontakten gebildet wird, sogenannten externen Kontakten, topologisch auf der einen und anderen Seite der Interdigitations-Elektroden dieses Transistors angeordnet, wobei für jeden Transistor alle Source-Elektrodenkontakte direkt untereinander mit einem Leiter verbunden sind und wobei der eine der beiden externen Source-Elektrodenkontakte, der sogenannte erste Kontakt, den besagten ersten Zweig bildet, direkt zum Massekontakt angeschlossen, und der andere dieser beiden externen Source-Elektrodenkontakte, der sogenannte zweite Kontakt, den sogenannten zweiten Zweig bildet, direkt über den besagten Widerstand an den zweiten Massekontakt angeschlossen.

5. Halbleitervorrichtung nach Anspruch 4, dadurch gekennzeichnet, daß jeder einen Source-Kontakt mit einem Massekontakt verbindende Widerstand schwachen Wertes gewählt wird, und daß jeder Massekontakt gewählt wird, um in Hyperfrequenzen eine schwache Induktanz zu bilden, derart, daß mit dieser Anordnung die Source jedes Transistors einerseits über diese schwache Induktanz mit der Masse und andererseits mit den Sourcen der vorhergehenden und nachfolgenden Transistoren verbunden, über einen dieser Widerstände geringen Wertes.

6. Vorrichtung nach Anspruch 5, dadurch gekennzeichnet, daß die Transistoren zur Bildung des Kettenverstärkers topologisch in Reihe an der Substratoberfläche angeordnet sind, mit ihren Interdigitations-Elektrodenkontakte senkrecht zu dieser Reihe angeordnet, jeder Transistor hat den besagten zweiten Source-Elektrodenkontakt gegenüber dem ersten Source-Elektrodenkontakt des darauffolgenden Transistors der Verstärkerschaltung angeordnet, die von diesen beiden Transistoren geteilten Massekontakte sind topologisch zwischen diesen Transistoren angeordnet und zu ihnen ausgerichtet, neben dem besagten zweiten und dem besagten ersten gegenüberliegenden Source-Elektrodenkontakt, und für jeden Transistor ist der besagte Widerstand geringen Wertes topologisch überlappend zwischen dem besagten zweiten Elektrodenkontakt und dem an ihn angrenzenden Massekontakt angebracht.

7. Vorrichtung nach einem der Ansprüche 3 bis 6, dadurch gekennzeichnet, daß jede Stufe des Kettenverstärkers vom Kaskodentyp ist, in dem man jeden sogenannten niederen Transistor des Kettenverstärkers mit gemeinsamer Source an der Masse einen sogenannten hohen Transistor mit gemeinsamem Gitter an der Masse in Hoch- und/oder Hyperfrequenzen zuteilt, wobei das Gitter die besagte erste Elektrode dieser Kaskodenstufe bildet und von der Masse kontinuierlich über Kapazitäten isoliert ist.

8. Vorrichtung nach einem der vorhergehenden Ansprüche, dadurch gekennzeichnet, daß die Verstärkerschaltung monolithisch auf einem Substrat integriert ist, mittels einer sogenannten Mikrobandleitertechnologie, nach der die aktiven Elemente, die Verbindungen und Kontakte der Masse auf einer Flächee des Substrats erstellt werden, das auf der anderen Seite eine Massefläche trägt, die Verbindung zwischen den Massekontakten und der Massefläche wird mit metallisierten Löchern hergestellt, in jedem Massekontakt vorgesehen.

9. Vorrichtung nach einen der vorhergehenden Ansprüchen, dadurch gekennzeichnet, daß die Verstärkerschaltung monolithisch auf eineme Substrat integriert ist, aus einem Material der Gruppe III-IV aus z.B. Galliumarsenid (GaAs).

10. Vorrichtung nach einem der Ansprüche 1 oder 2, dadurch gekennzeichnet, daß die Kettenschaltung ein Mischer ist.

Claims

1. A semiconductor device comprising a monolithic integrated distributed amplifier circuit disposed on a substrate for operating at frequencies in the high frequency and/or microwave range, this distributed circuit including a plurality of coupled stages each having at least a transistor including electrodes, at least one of these electrodes called, first electrode, being AC coupled to ground, characterized in that in each considered AC stage said first electrode is connected to ground through two branches, one branch called first branch being connected directly to a first ground stub, and one branch called second branch being connected to a second ground stub through a resistor.

2. A device as claimed in claim 1, characterized in that in the distributed circuit the stages are disposed opposite to one another, so that for each considered stage the first ground stub is used in common with the second ground stub of the preceding stage or of the next stage, and the second ground stub is shared with the first ground stub of the next stage or of the preceding stage respectively, so that with this arrangement in the AC mode, said first electrode of the transistor in each considered stage is connected, on the one hand, to ground via the inductor of the first ground stub, and, on the other hand, to said first electrodes of the preceding and next stages by the resistors of their second branches respectively.

3. A semiconductor device as claimed in claim 2, characterized in that the distributed circuit is a high-gain broadband amplifier circuit, this amplifier circuit comprising a plurality of coupled stages having each at least one field effect transistor whose source forms said first electrode and whose gate and drain are connected to a line called gate line and to a line called drain line respectively, formed by inductors.

4. A semiconductor device as claimed in Claim 3, characterized in that in this amplifier circuit each transistor is an interdigitated transistor whose source is formed by at least two source stubs, called external stubs, disposed on either one of the two sides of the other interdigitated electrode stubs of this transistor, in that for each transistor all the source stubs are directly interconnected by means of a conductor, and in that one of the two external source stubs, called first stub, forms said first branch connected directly to the first ground stub and the other of the two external source stubs, called second stub, forms said second branch connected to the second ground stub through said resistor.

5. A semiconductor device as claimed in Claim 4, characterized in that each resistor which connects a source stub to a ground stub is chosen to have a low value, and each ground stub is chosen to form a low-value inductance in the microwave range, so that because of this arrangement the source of each transistor is connected to ground by this low-value inductance and also to the sources of the preceding and following transistors by one of said low-value resistors.

6. A device as claimed in Claim 5, characterized in that the transistors for forming the distributed amplifier are disposed in line on the surface of the substrate, with their interdigitated electrode stubs disposed perpendicularly to this line, each transistor having said second source stub facing said first source stub of the next transistor of the amplifier circuit, in that the ground stubs shared by these two transistors are disposed between these transistors and in line therewith, in similar fashion to said second and said first facing source stubs, and in that for each transistor said low-value resistance is realised by the overlap between said second source stub and the ground stub adjacent thereto.

7. A device as claimed in Claim 6, characterized in that each stage of the distributed amplifier is of the cascoded type in which there is coupled to each transistor called bottom transistor of the distributed amplifier in a common source arrangement to ground, a transistor called top transistor in a common gate arrangement to ground in the high frequency and/or microwave range, the gate forming said first electrode of this cascoded stage and being DC isolated from ground by capacitors.

8. A device as claimed in one of the preceding Claims, characterized in that the amplifier circuit is monolithically integrated in a substrate by a technology called microstrip technology, according to which the active elements, the connections and the ground stubs are realised on one of the surfaces of a substrate which carries a ground plane on its other surface, the connection between the ground stubs and the ground plane being realised by means of via holes made in each ground stub.

9. A device as claimed in one of the preceding Claims, characterized in that the amplifier circuit is monolithically integrated in a substrate of a material of the III-IV group, for example, gallium arsenide (GaAs).

10. A device as claimed in one of the Claims 1 or 2, characterized in that the distributed circuit is a mixer.

FIG.1

FIG. 2a

EP 0 596 568 B1

FIG. 2b

EP 0 596 568 B1

FIG. 3a

FIG. 3b

15

FIG.3c

FIG. 4